# FASCICULE DE BREVET EUROPEEN

(11) **EP 0 849 739 B1**
(45) Date de publication et mention de la délivrance du brevet: **20.10.1999**
(21) Numéro de dépôt: 97402806.0
(22) Date de dépôt: 21.11.1997
(51) Int. Cl.: G11C 7/00, G11C 8/04

(54) **Dispositif et procédé de lecture incrémentale d'une mémoire**
Anordnung und Verfahren zum inkrementellen Lesen eines Speichers
Device and method for incremental reading of a memory

(30) Priorité: 17.12.1996 FR 9615514
(43) Date de publication de la demande: 24.06.1998
(73) Titulaire: STMicroelectronics S.A., 94250 Gentilly (FR)
(72) Inventeur: Gaultier, Jean-Marie, 75116 Paris (FR); Silvestre De Ferron, Gérard, 75116 Paris (FR)
(74) Mandataire: Ballot, Paul Denis Jacques

(56) Documents cités:
- EP-A- 0 262 413
- EP-A- 0 333 231

## Description

L'invention concerne les mémoires des unités centrales de traitement de micro-ordinateurs et, plus particulièrement, un dispositif et un procédé de lecture incrémentale d'une telle mémoire de manière à améliorer ses performances en augmentant la vitesse de sortie des données, dans le cas où la lecture s'effectue à des adresses consécutives de la mémoire selon le mode dit de "lecture en rafale".

Les données contenues dans une mémoire sont lues à l'aide d'adresses ou codes d'adressage qui sont fournis successivement à des circuits d'adressage de la mémoire par l'unité de traitement du micro-ordinateur ou micro-contrôleur, chaque code d'adressage correspondant à une donnée qui est ensuite traitée par l'unité de traitement selon l'instruction en cours d'exécution.

Dans ce mode de lecture, les données contenues dans la mémoire ne sont lues qu'au fur et à mesure de l'arrivée des codes d'adressage, le code d'adressage de la donnée suivante à traiter n'étant fourni qu'après transfert de la donnée précédente dans l'unité de traitement.

Ce mode de lecture conduit à un temps mort dans la lecture de la mémoire et donc à une perte de temps, ce qui est préjudiciable à la vitesse de calcul de l'unité de traitement.

Un but de la présente invention est donc de réduire ce temps de lecture et d'augmenter ainsi la vitesse de sortie des données.

Pour atteindre ce but, l'invention propose de faire suivre immédiatement la lecture d'une données à une adresse par la lecture de la donnée contenue à l'adresse suivante, cette dernière adresse étant obtenue par incrémentation d'une unité de l'adresse précédente.

Ainsi, dans le cas de l'exécution d'une instruction qui utilise les données contenues à des adresses consécutives de la mémoire, il n'est pas nécessaire d'attendre l'arrivée du code d'adressage en provenance de l'unité de traitement pour lire la mémoire à ces adresses consécutives.

Dans le cas où l'adresse fournie par l'unité de traitement ne correspond pas à l'adresse suivante de la mémoire, la donnée lue à cette dernière adresse n'est pas transférée à l'unité de traitement et n'est donc pas prise en compte.

Le brevet EP 0262413 décrit une mémoire comprenant un compteur pour incrémenter le contenu du registre d'adresse.

Pour mettre en oeuvre le procédé selon l'invention, les circuits d'adressage et de lecture de la mémoire doivent être modifiés et complétés.

Ainsi, les circuits de lecture doivent comprendre, outre un registre de lecture, un registre supplémentaire dit de donnée pour enregistrer la donnée lue et ainsi libérer le registre de lecture pour la lecture à l'adresse suivante et des circuits électroniques de transfert entre le registre de lecture et le registre de donnée pour réaliser le passage de la donnée du registre de lecture au registre de donnée.

Par ailleurs, le registre d'adressage de la mémoire doit être du type incrémentable, l'incrémentation étant commandée par un signal fourni par un circuit de séquencement. Ce circuit de séquencement fournit un autre signal commandant par ailleurs les circuits électroniques de transfert entre le registre de lecture et le registre de donnée.

L'invention concerne donc un dispositif de lecture incrémentale d'une mémoire d'une unité centrale d'un micro-ordinateur à laquelle sont associés des circuits d'adressage des cellules de ladite mémoire comprenant un registre d'adresse, des circuits de lecture des signaux lus dans les cellules de ladite mémoire sélectionnée par ledits circuits d'adressage comprenant un premier registre dit de lecture dans lequel les signaux lus sont enregistrés sous forme binaire, et
des moyens d'incrémentation pour augmenter d'au moins une unité le contenu du registre d'adresse de manière qu'il adresse les cellules de mémoire correspondant à l'adresse qui suit celle qu'il contient, caractérisé en ce qu'il comprend
des moyens de mémorisation pour enregistrer le contenu du registre de lecture de manière qu'il puisse enregistrer les signaux lus dans les cellules de mémoire correspondant à l'adresse suivante.

Dans ce dispositif, les moyens d'incrémentation pour incrémenter le contenu du registre d'adresse comprennent un circuit de séquencement qui est commandé par des signaux fournis par l'unité centrale et qui fournit un signal d'incrémentation du registre d'adresse.

Les moyens de mémorisation pour enregistrer le contenu du registre de lecture comprennent un deuxième registre dit de donnée et des circuits électroniques de transfert qui sont commandés par un signal fourni par les moyens d'incrémentation du registre d'adresse.

L'invention concerne également un procédé de lecture incrémentale d'une mémoire d'une unité centrale de traitement d'un micro-ordinateur à laquelle sont associés des circuits d'adressage des cellules de ladite mémoire comprenant un registre d'adresse et des circuits de lecture des signaux lus dans les cellules de ladite mémoire sélectionnées par lesdits circuits d'adressage comprenant un premier registre dit de lecture dans lequel les signaux lus sont enregistrés sous forme binaire, caractérisé en ce qu'il comprend les étapes suivantes :
(a) - Enregistrement par l'unité centrale de traitement d'un code d'adressage dans le registre d'adresse ;
(b) - Lecture des cellules de la mémoire sélectionnées par le code d'adressage ;
(c) - Enregistrement des signaux lus lors de l'étape (b) dans le registre de lecture puis, dans un deuxième registre dit de donnée ;
(d) - Transfert du contenu du registre de donnée vers l'unité centrale ;
(e) - Incrémentation d'au moins une unité du contenu du registre d'adresse pour obtenir un nouveau code d'adressage ;
(f) - Lecture des cellules de mémoire sélectionnées par le nouveau code d'adressage obtenu par l'opération (e) ;
(g) - Enregistrement des signaux lus lors de l'étape (f) dans le registre de lecture puis dans le registre de donnée ;
(h) - Transfert du contenu du registre de donnée vers l'unité centrale si le code d'adressage suivant correspond à l'adresse résultant de l'étape (e), puis retour à l'étape (e) ; et
(i) - Retour à l'étape (a) si le code d'adressage suivant ne correspond pas à l'adresse résultant de l'étape (e).

Dans une variante du procédé, l'étape (e) d'incrémentation peut intervenir entre les étapes (c) et (d).

L'invention sera maintenant décrite en relation avec un exemple particulier de réalisation , ladite description étant faite à l'aide des dessins ci-annexés dans lesquels :
- la figure 1 est un schéma fonctionnel d'un dispositif de lecture incrémentale d'une mémoire selon la présente invention,
- la figure 2 est un diagramme d'un cycle de lecture selon le procédé de l'invention, et
- les figures 3-a à 3-d sont des diagrammes temporels de signaux.

De manière connue, à une mémoire 10 sont associés des circuits de sélection 12 qui permettent de sélectionner des cellules de la mémoire et des circuits de lecture 14 qui permettent de "recueillir" les informations ou données lues dans les cellules sélectionnées. Les adresses des cellules de mémoire sont fournies aux circuits de sélection 12 par un registre d'adresse 16 qui les reçoit d'une unité de traitement 18 par l'intermédiaire d'un circuit d'entrées/sorties 20 et d'un bus bidirectionnel 46. Les circuits de sélection 12 et le registre d'adresse 16 constituent des circuits d'adressage 48. Ce circuit d'entées/sorties 20 reçoit par ailleurs les informations ou données lues dans la mémoire 10 par l'intermédiaire des circuits de lecture 14, d'amplificateurs de sortie 22 et d'un bus unidirectionnel 44.

Les circuits de lecture 14 comprennent des amplificateurs de lecture 24 qui amplifient les signaux lus dans les cellules de mémoire sélectionnées et un registre de lecture 26 qui enregistre ou mémorise les signaux lus sous forme binaire.

Le transfert des informations binaires contenues dans le registre de lecture 26, vers l'unité de traitement 18 s'effectue en présence d'un signal OE fourni par l'unité de traitement 18 sur un conducteur 86.

La mémoire 10 comprend également des circuits d'enregistrement des données qui ne seront pas décrits ici car l'invention ne concerne que la lecture de la mémoire 10.

Selon l'invention, le dispositif de lecture incrémentale comprend, outre les éléments décrits ci-dessus, un registre dit de donnée 28 qui est connecté entre le registre de lecture 26 et les amplificateurs de sortie 22. Les bornes d'entrée du registre de donnée 28 sont connectées aux bornes de sortie du registre de lecture 26 par l'intermédiaire de circuits électroniques ou portes électroniques 30. Les bornes de sortie du registre de donnée 28 sont connectées aux circuits d'entrées/sorties 20 par l'intermédiaire des amplificateurs de sortie 22 et du bus unidirectionnel 44.

Selon l'invention, le registre d'adresse 16 est du type à incrémentation obtenue par un premier signal INC fourni par un circuit de séquencement 32 sur un conducteur 88. Le circuit de séquencement 32 fournit un deuxième signal TRA sur un conducteur 90 qui commande les portes électroniques 30.

Le circuit de séquencement 32 est commandé par des signaux ALE et ADV qui sont fournis par l'unité de traitement 18 sur des conducteurs 82 et 84 respectivement. Le signal ALE signifie que le code d'adressage à prendre en compte est celui fourni par l'unité de traitement 18 sur le bus 46 tandis que le signal ADV signifie que le code d'adressage à prendre en compte est celui qui résulte de l'incrémentation.

Le circuit de séquencement 32 reçoit également un signal ATD dit de "Détection de Transition d'Adresse" du registre d'adresse 16 sur un conducteur 92, signal qui indique que le code d'adressage contenu dans le registre d'adresse a changé.

Le circuit de séquencement 32 comprend essentiellement un circuit horloge qui fournit des signaux cadencés et des circuits logiques d'élaboration des signaux INC et TRA.

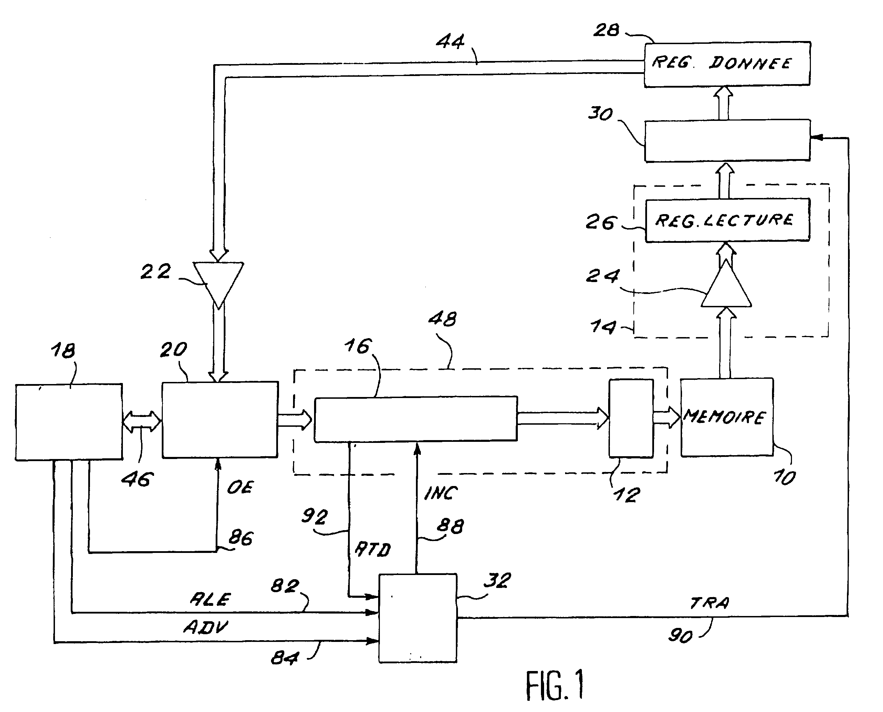

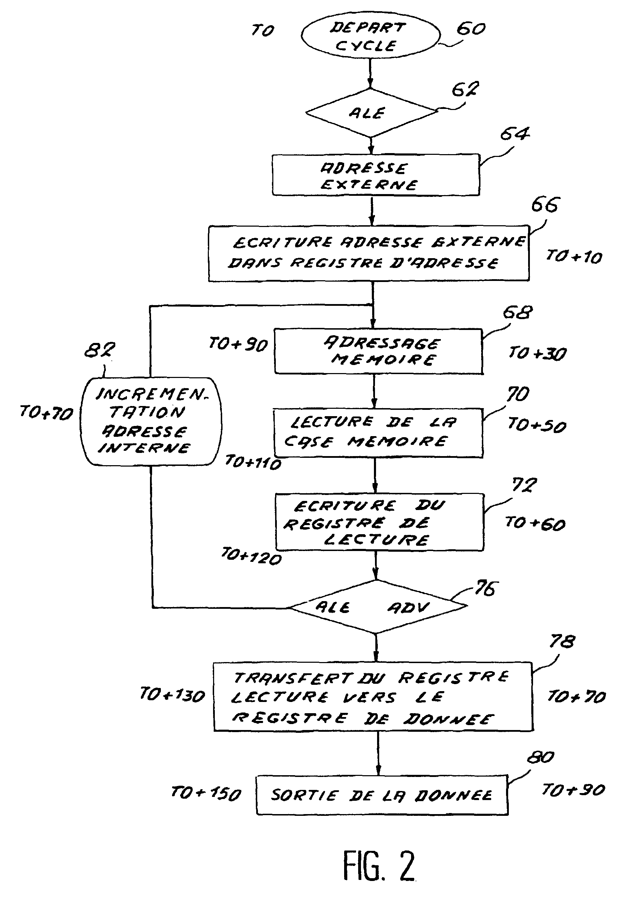

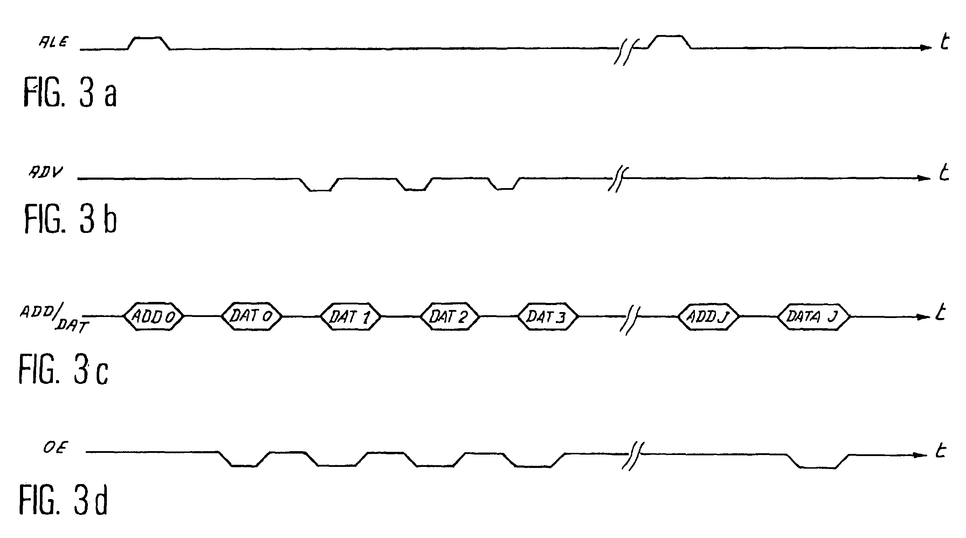

Le fonctionnement du dispositif de la figure 1 est le suivant en relation avec les diagrammes des figures 2 et 3.

Au départ TO d'un cycle de lecture de la mémoire 10 (ellipse 60), l'unité de traitement 18 fournit le signal ALE (losange 62) et le code d'adressage (rectangle 64) de la mémoire qui est enregistré au temps (T0+10ns) dans le registre d'adresse 16.

L'adressage ou sélection de la case mémoire s'effectue au temps (T0+30ns) par l'intermédiaire des circuits de sélection 12 (rectangle 68).

La lecture de la case mémoire sélectionnée s'effectue au temps (T0+50ns) (rectangle 70) et l'enregistrement ou l'écriture sous forme binaire des signaux lus dans le registre de lecture 26 s'effectue au temps (T0+60ns) (rectangle 72).

Le transfert (signal TRA) de la donnée du registre de lecture 26 au registre de donnée 28 s'effectue au temps (T0+70ns) en présence d'un signal ALE correspondant à un nouveau code d'adressage qui ne suit pas le précédent ou d'un signal ADV indiquant que le code d'adressage est celui qui suit le précédent (rectangle 78).

La donnée contenue dans le registre de donnée 28 est transmise à l'unité de traitement 18 par l'intermédiaire du circuit d'entrées/sorties 20 au temps (T0+90ns) qui est commandée par le signal OE de l'unité de traitement 18 (rectangle 80).

Dans le mode de fonctionnement de l'art antérieur, le signal ALE suivant et le code d'adressage suivant ne peuvent être pris en compte qu'à cet instant.

Dans le mode selon l'invention, dès que le transfert du registre de lecture 26 vers le registre de donnée 28 a été effectué, le registre de lecture 26 est libre pour enregistrer le contenu d'une nouvelle case de mémoire, c'est-à-dire au temps (T0+70ns). A cet instant, le signal ADV permet l'incrémentation (rectangle 82) de l'adresse contenue dans le registre d'adresse 16 de sorte que la mémoire 10 est sélectionnée (rectangle 68) au temps (T0+90ns), que la lecture (rectangle 70) s'effectue au temps (T0+110ns), que l'écriture (rectangle 72) dans le registre de lecture s'effectue au temps (T0+120ns), que le transfert (rectangle 78) dans le registre de donnée s'effectue au temps (T0+130ns) et que la sortie (rectangle 80) vers l'unité de traitement s'effectue au temps (T0+150ns).

La comparaison de ces différents instants montre que le cycle normal avec un signal ALE est de 90ns et qu'il est de 60ns avec un signal ADV correspondant à l'adresse suivante, soit un gain d'un tiers.

Les diagrammes des figures 3-a à 3d sont respectivement des diagrammes temporels des signaux ALE, ADV, ADD/DAT et OE, le signal ADD/DAT correspondant soit au transfert du code d'adressage ADD de l'unité de traitement 18 vers le registre d'adresse 16, soit au transfert de la donnée DAT lue du registre de donnée 28 vers l'unité de traitement 18, les transferts s'effectuant via le circuit d'entrées/sorties 20 et le bus bidirectionnel 46. Le chiffre 0, 1, 2, 3 ou la lettre J associée à l'adresse ADD ou à la donnée DAT indique qu'il s'agit de l'adresse ou de la donnée de rang 0, 1, 2, 3, ... J.

La séquence des opérations est la suivante :
(A) -enregistrement du code d'adressage fourni par l'unité centrale 18 dans le registre d'adresse 16 en présence du signal ALE;
(B)-adressage de la mémoire 10 pour sélectionner les cellules correspondant à l'adresse contenue dans le registre d'adresse 16;
(C)-lecture des cellules de mémoire sélectionnées;
(D)-enregistrement des signaux lus dans les cellules de mémoire sélectionnées dans le registre de lecture 26,
(E)-enregistrement du contenu du registre de lecture 26 dans le registre de donnée 28 en présence du signal TRA,
(F1)-transfert du contenu du registre de donnée 28 vers l'unité centrale 18 par l'intermédiaire du circuit d'entrées/sorties 20 en présence des signaux ALE et OE;
(F2)-incrémentation de l'adresse contenue dans le registre d'adresse 16;
(G)-adressage de la mémoire 10 pour sélectionner les cellules correspondant à d'adresse incrémentée contenue dans le registre d'adresse 16;
(H)-lecture des cellules de mémoire sélectionnées,
(I)-enregistrement des signaux lus dans les cellules de mémoire sélectionnées dans le registre de lecture 26;
(J)-enregistrement du contenu du registre de lecture dans le registre de donnée 28 en présence du signal TRA;
(K1)-transfert du contenu du registre de donnée 18 vers l'unité centrale 18 par l'intermédiaire du circuit d'entrées/sorties 20 en présence des signaux ADV et OE;
(K2)-Retour à l'étape (F2) en présence du signal ADV;
(K3)-Retour à l'étape (A) en présence du signal ALE.

Il est à remarquer que les étapes (C) et (H) de lecture des cellules de mémoire sélectionnées peuvent comprendre, selon le type de mémoire, une étape de précharge des cellules de mémoire avant leur lecture réelle.

Les opérations qui viennent d'être décrites peuvent se résumer aux étapes principales suivantes :
(a) - Enregistrement par l'unité centrale 18 d'un code d'adressage dans le registre d'adresse 16 ;
(b) - Lecture des cellules de la mémoire sélectionnées par le code d'adressage ;
(c) - Enregistrement des signaux lus lors de l'étape (b) dans le registre de lecture 26 puis, dans un registre de donnée 28 ;
(d) - Transfert du contenu du registre de donnée vers l'unité centrale de traitement 18 ;
(e) - Incrémentation d'au moins une unité du contenu du registre d'adresse 16 pour obtenir un nouveau code d'adressage ;
(f) - Lecture des cellules de mémoire sélectionnées par le nouveau code d'adressage obtenu par l'opération (d) ;
(g) - Enregistrement des signaux lus lors de l'étape (f) dans le registre de lecture 26 puis dans le registre de donnée 28 ;
(h) - Transfert du contenu du registre de donnée 28 vers l'unité centrale de traitement 18 si le code d'adressage suivant correspond à l'adresse résultant de l'étape (e), puis retour à l'étape (e) ; et
(i) - Retour à l'étape (a) si le code d'adressage suivant ne correspond pas à l'adresse résultant de l'étape (e).

L'opération ou étape (e) d'incrémentation peut intervenir dès l'accomplissement de l'opération (c), c'est-à-dire dès que le contenu du registre de lecture a été transféré dans le registre de donnée 28, ce qui permet de gagner du temps et donc d'augmenter la vitesse.

L'invention a été décrite avec une incrémentation d'une unité ; cependant, cette incrémentation peut avoir une valeur entière quelconque 2,3 ... n.

## Revendications

1. Dispositif de lecture incrémentale d'une mémoire (10) d'une unité centrale de traitement (18) d'un micro-ordinateur à laquelle sont associés des circuits d'adressage (12, 16) des cellules de ladite mémoire comprenant un registre d'adresse (16), et des circuits de lecture (14) des signaux lus dans les cellules de ladite mémoire sélectionnées par lesdits circuits d'adressage comprenant au moins un premier registre dit de lecture (26) dans lequel les signaux lus sont enregistrés sous forme binaire, ledit dispositif comprenant
des moyens d'incrémentation (32) pour augmenter d'au moins une unité le contenu du registre d'adresse (16) de manière qu'il adresse les cellules de mémoire correspondant à l'adresse qui suit celle qu'il contient, et étant caractérisé en ce qu'il comprend, en outre,
des moyens de mémorisation pour enregistrer le contenu du premier registre de lecture (26) de manière qu'il puisse enregistrer les signaux lus dans les cellules de mémoire correspondant à l'adresse suivante.

2. Dispositif selon la revendication 1, caractérisé en ce que les moyens d'incrémentation du contenu du registre d'adresse (16) comprennent un circuit de séquencement (32) qui est commandé par des signaux (ALE,ADV) fournis par l'unité centrale et qui fournit un signal (INC) d'incrémentation du registre d'adresse (16).

3. Dispositif selon la revendication 1 ou 2, caractérisé en ce que les moyens de mémorisation pour enregistrer le contenu du registre de lecture (26) comprennent un registre de donnée (28) et des circuits électroniques de transfert (30) qui sont commandés par un signal (TRA) fourni par les moyens d'incrémentation (32) du registre d'adresse (16).

4. Procédé de lecture incrémentale d'une mémoire (10) d'une unité centrale de traitement (18) d'un micro-ordinateur à laquelle sont associés des circuits d'adressage (12, 16) des cellules de ladite mémoire comprenant un registre d'adresse (16) et des circuits de lecture (14) des signaux lus dans les cellules de ladite mémoire (10) sélectionnées par lesdits circuits d'adressage comprenant un premier registre dit de lecture (26) dans lequel les signaux lus sont enregistrés sous forme binaire, caractérisé en ce qu'il comprend les étapes suivantes :
(a) - Enregistrement par l'unité centrale de traitement (18) d'un code d'adressage dans le registre d'adresse (16) ;
(b) - Lecture des cellules de la mémoire sélectionnées par le code d'adressage ;
(c) - Enregistrement des signaux lus lors de l'étape (b) dans le registre de lecture (26) puis, dans un registre de donnée (28) ;
(d) - Transfert du contenu du registre de donnée vers l'unité centrale de traitement (18) ;
(e) - Incrémentation d'au moins une unité du contenu du registre d'adresse (16) pour obtenir un nouveau code d'adressage ;
(f) - Lecture des cellules de mémoire sélectionnées par le nouveau code d'adressage obtenu par l'opération (d) ;
(g) - Enregistrement des signaux lus lors de l'étape (f) dans le registre de lecture (26) puis dans le registre de donnée (28) ;
(h) - Transfert du contenu du registre de donnée (28) vers l'unité centrale (18) de traitement si le code d'adressage suivant correspond à l'adresse résultant de l'étape (e), puis retour à l'étape (e) ; et
(i) - Retour à l'étape (a) si le code d'adressage suivant ne correspond pas à l'adresse résultant de l'étape (e).

5. Procédé de lecture selon la revendication 4, caractérisé en ce que l'étape (e) intervient entre les étapes (c) et (d).

## Patentansprüche

1. Vorrichtung zum inkrementellen Lesen eines Speichers (10) einer zentral Verarbeitungseinheit (18) eines Mikrorechners, dem Schaltung zum Adressieren (12, 16) von Zellen dieses Speichers mit einem Adreßregister (16) zugeordnet sind sowie Schaltungen zum Lesen (14) von Signalen, welche aus den Zellen des Speichers gelesen werden, die von den Adressierschaltungen ausgewählt werden, welche wenigstens ein erstes Register umfassen, das Leseregister (16) genannt wird und in dem die gelesenen Signale in binärer Form gespeichert werden, mit folgenden Merkmalen :
Inkrementiermittel (32) zum Erhöhen des Inhalts des Adreßregisters (16) um wenigstens eine Einheit, so daß es die Speicherzellen adressiert, welche der Adresse entsprechen, die der enthaltenen Adresse folgt, und gekennzeichnet durch
Speichermittel zum Speichern des Inhalts des ersten Leseregisters (26), so daß es aus den Speicherzellen gelesene Signale speichern kann, welche der folgenden Adresse entsprechen.

2. Vorrichtung nach Anspruch 1, dadurch gekennzeichnet, daß die Mittel zum Inkremenieren des Inhalts des Adreßregisters (16) eine Folgesteuerschaltung (32) umfassen, die von Signalen (ALE, ADV) gesteuert wird, welche von der zentralen Verarbeitungseinheit geliefert werden, und die ein Inkrementiersignal (INC) an das Adreßregister (16) liefert.

3. Vorrichtung nach Anspruch 1 oder 2, dadurch gekennzeichnet, daß die Speichermittel zum Speichern des Inhalts des Leseregisters (26) ein Datenregister (18) und eine elektronische Übertragungsschaltung (30) umfassen, die von einem Signal (TRA) gesteuert werden, welches von den Mitteln zum Inkrementieren (32) des Adreßregisters (16) geliefert wird.

4. Verfahren zum inkrementellen Lesen eines Speichers (10) einer zentralen Verarbeitungseinheit (18) eines Mikrorechners, dem Schaltung zum Adressieren (12, 16) von Zellen dieses Speichers mit einem Adreßregister (16) zugeordnet sind sowie Schaltungen zum Lesen (14) von Signalen, welche aus den Zellen des Speichers (10) gelesen werden, die von den Adressierschaltungen ausgewählt werden, welche wenigstens ein erstes Register umfassen, das Leseregister (26) genannt wird und in dem die gelesenen Signale in binärer Form gespeichert sind, gekennzeichnet durch die folgenden Verfahrensschritte :
(a) Speichern eines Adreßcodes in dem Adreßregister (16) durch die zentrale Verarbeitungseinheit (18);
(b) Lesen von durch den Adreßcode ausgewählten Zellen des Speichers;
(c) Speichern von im Schritt (b) gelesen Signalen in dem Leseregister (26) und dann in einem Datenregister (28),
(d) Übertragen des Inhalts des Datenregisters zur zentralen Verarbeitungseinheit (18);
(e) Inkrementieren des Inhalts des Adreßregisters (16) um wenigstens eine Einheit, um einen neuen Adreßcode zu erhalten;
(f) Lesen der durch den neuen Adreßcode, der im Schritt (d) erhalten wurde, ausgewählten Speicherzellen;
(g) Speichern der im Schritt (f) gelesenen Signale in dem Leseregister (26) und dann in dem Datenregister (28),
(h) Übertragen des Inhalts des Datenregisters (28) zur zentralen Verarbeitungseinheit (18), wenn der folgende Adreßcode der Adresse entspricht, die sich aus dem Schritt (e) ergibt, und dann Zurückkehren zum Schritt (e);
(i) Zurückkehren zum Schritt (a), wenn der folgende Adreßcode nicht der Adresse entspricht, die sich im Schritt (e) ergibt.

5. Verfahren zum Lesen nach Anspruch 4, dadurch gekennzeichnet, daß der Schritt (e) zwischen die Schritte (c ) und (d) geschaltet ist.

## Claims

1. A device for reading by increments a memory (10) of a central processing unit (18) of a micro-computer to which circuits (12, 16) with an address register (16) are connected for addressing the cells of said memory, and circuits (14) for reading signals read in the cells of said memory selected by said addressing circuits, having at least a first register (26) referred to as the read register in which the signals read are stored in binary form, said device having incrementation means (32) for increasing the contents of the address register (16) by at least one unit so that it addresses the memory cells to correspond to the address following the one contained therein and being characterised in that it also has memory means for storing the contents of the first address register (26) so that it can save the signals read in the memory cells corresponding to the subsequent address.

2. A device as claimed in claim 1, characterised in that the means for incrementing the contents of the address register (16) have a sequencing circuit (32) which is controlled by signals (ALE, ADV) supplied by the central unit and which supplies a signal (INC) to increment the address register (16).

3. A device as claimed in claim 1 or 2, characterised in that the memory means for storing the contents of the read register (26) have a data register (28) and electronic transfer circuits (30) which are controlled by a signal (TRA) supplied by the incrementation means (32) of the address register (16).

4. A method of reading by increments a memory (10) of a central processing unit (18) of a micro-computer, to which circuits (12, 16) having an address register (16) are connected for addressing the cells of said memory, and circuits (14) for reading signals read in the cells of said memory (10) selected by said addressing circuits having a first register referred to as the read register (26) in which the signals read are stored in binary form, characterised in that it consists of the following steps:
(a) - the central processing unit (18) stores an address code in the address register (16);
(b) - the memory cells selected by the address code are read;
(c) - the signals read during step (b) are stored in the read register (26) and then in a data register (28);
(d) - the contents of the data register are transferred to the central processing unit (18);
(e) - the contents of the address register (16) are incremented by at least one unit in order to obtain a new address code;
(f) - the memory cells selected by the new address code obtained by operation (d) are read;
(g) - the signals read during step (f) are stored in the read register (26) and then in the data register (28);
(h) - the contents of the data register (28) are transferred to the central processing unit (18) if the next address code corresponds to the address resulting from step (e), followed by a return to step (e); and
(i) - return to step (a) if the next address code does not correspond to the address resulting from step (e).

5. A reading method as claimed in claim 4, characterised in that step (e) is performed between steps (c) and (d).
